(19) Europäisches Patentamt
European Patent Office
Office européen des brevets

(11) **EP 1 851 556 B1**

(12) **EUROPÄISCHE PATENTSCHRIFT**

(45) Veröffentlichungstag und Bekanntmachung des Hinweises auf die Patenterteilung:
**01.07.2009 Patentblatt 2009/27**

(21) Anmeldenummer: **06705345.4**

(22) Anmeldetag: **17.02.2006**

(51) Int Cl.:
**G01R 15/18** $^{(2006.01)}$

(86) Internationale Anmeldenummer:
**PCT/CH2006/000105**

(87) Internationale Veröffentlichungsnummer:
**WO 2006/089443 (31.08.2006 Gazette 2006/35)**

(54) **RINGKERN-STROMWANDLER MIT PHASENKOMPENSATIONSSCHALTUNG**

TOROIDAL CORE CURRENT TRANSFORMER COMPRISING A PHASE COMPENSATION CIRCUIT

TRANSFORMATEUR TOROÏDAL À CIRCUIT DE COMPENSATION DE PHASE

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**HR**

(30) Priorität: **22.02.2005 CH 306052005**

(43) Veröffentlichungstag der Anmeldung:
**07.11.2007 Patentblatt 2007/45**

(73) Patentinhaber: **Trench Switzerland AG**
**4052 Basel (CH)**

(72) Erfinder:
• **MINKNER, Ruthard**
**CH-4148 Pfeffingen (CH)**
• **SCHMID, Joachim**
**79588 Efringen-Kirchen (DE)**
• **FLURI, Rolf**
**CH-4057 Basel (CH)**

(74) Vertreter: **Bohest AG**
**Postfach 160**
**4003 Basel (CH)**

(56) Entgegenhaltungen:
**US-A- 4 198 595 US-A- 6 094 044**
**US-B1- 6 670 799**

• **NOVEL MAGNETIC MATERIALS INCREASE PERFORMANCE OF CURRENT TRANSFORMERS FOR ELECTRONIC WATT-HOUR METERS: "http://www.metering.com/vac/" METERING INTERNATIONAL, vol. 2002, no. 1, 1 January 2002 (2002-01-01), XP002380563**

EP 1 851 556 B1

**Beschreibung**

Die Erfindung betrifft einen Ringkern-Stromwandler gemäss dem Oberbegriff des unabhängigen Vorrichtungsanspruchs sowie ein Verfahren zur Ermittlung des Primärstroms mit Hilfe eines Ringkern-Stromwandlers gemäss dem Oberbegriff des unabhängigen Verfahrensanspruchs.

Solche Ringkern-Stromwandler können dazu eingesetzt werden, einen hohen Primärstrom in einem Primärleiter über einen Ringkern in einen um ein Vielfaches niedrigeren Sekundärstrom in einer Sekundärwicklung um den Ringkern zu wandeln. Bisher kommen solche Ringkern-Stromwandler beispielsweise für Verrechnungszwecke wie auch für Schutzzwecke zum Einsatz, wobei für Verrechnungszwecke und für Schutzzwecke verschiedene Arten von Stromwandler (Spannungsausgang, Stromausgang) eingesetzt werden.

Ringkern-Stromwandler mit Stromausgang werden heute im allgemeinen nach den Standards IEC 60044-1 und IEC 60044-6 ausgelegt, gemäss welcher sich die Belastungsimpedanz (Bürde) nur in einem vorgeschriebenen, schmalen Band ändern darf (Belastungsimpedanz ist mehr oder weniger konstant). Ringkern-Stromwandler mit Stromausgang, aber variabler Bürde, sind Stand der Technik für die heute eingesetzten Strommessysteme.

Ausserdem kommen die genannten Ringkern-Stromwandler auch mit sekundärseitigem Spannungsausgang zum Einsatz, entsprechend dem Standard IEC 60044-8. Ein Beispiel für einen derartigen Ringkern-Stromwandler mit Spannungsausgang ist aus der WO-A-98/58267 bekannt. Andere Stromwandler sind aus US 4198595, US 6670799 und US 6094044 bekannt. Für den beschriebenen Ringkern-Stromwandler gilt für den Primärstrom die Beziehung

$$\underline{I}_P = \frac{\underline{U}_S}{\ddot{u} \cdot R_{Sh}}$$

wobei $\underline{I}_P$ den Primärstrom bezeichnet und $\underline{U}_S$ die Spannung am Messshunt $R_{Sh}$.

Allerdings tritt bei beiden Arten von Ringkern-Stromwandlern (Spannungsausgang, Stromausgang) durch die Verluste im Ringkern (Eisenverluste) und dem nötigen Magnetisierungsstrom des Ringkerns ein komplexer Übersetzungsfehler auf, der durch den Betragsfehler

$$|\varepsilon| = \frac{\frac{|\underline{I}_S|}{\ddot{u}} - |\underline{I}_P|}{|\underline{I}_P|} \cdot 100\%$$

und den Phasenfehler

$$\varphi = \varphi_P - \varphi_S$$

gegeben ist, wobei $\underline{I}_P$ und $\underline{I}_S$ für einen komplexen Primär- bzw. Sekundärstrom stehen, die durch ihre Beträge $|\underline{I}_P|$ und $|\underline{I}_S|$ und die zugehörigen Phasenwinkel $\varphi_P$ und $\varphi_S$ festgelegt sind.

Durch den Phasenfehler entstehen bei der Ermittlung des Primärstroms Fehler, so dass selbst kleine Phasenfehler z.B. bei der Ermittlung des Leistungsbezugs aus dem Netz für Energie intensive Betriebe ganz deutlich spürbare Konsequenzen auf der Kostenseite haben können. Es ist daher eine Aufgabe der Erfindung, einen Ringkern-Stromwandler vorzuschlagen, bei dem dieser Phasenfehler entweder vollständig oder quasi vollständig kompensiert ist. Weiterhin wünschenswert wäre auch, wenn der Stromwandler als Universal-Stromwandler sowohl mit Spannungsausgang gemäss IEC 60044-8 oder mit Stromausgang bei quasi konstanter Bürde gemäss IEC 60044-1 bzw. 60044-6 betrieben werden kann.

Erfindungsgemäss wird ein Ringkern-Stromwandler vorgeschlagen, wie er durch die Merkmale des unabhängigen Vorrichtungsanspruchs charakterisiert ist. Vorteilhafte Weiterbildungen des erfindungsgemässen Ringkern-Stromwandlers ergeben sich aus den Merkmalen der abhängigen Vorrichtungsansprüche.

Im besonderen betrifft die Erfindung einen Ringkern-Stromwandler beispielsweise für Mittel- und Hochspannungsanlagen. Er umfasst einen Primärleiter, der den Ringkern durchquert, sowie eine um den Ringkern gewickelte Sekundärwicklung. Sekundärseitig ist ein Messshunt oder eine Bürde vorgesehen. Zur Kompensation des Phasenfehlers zwischen Primärstrom und Sekundärstrom ist sekundärseitig eine passive Kompensationsschaltung vorgesehen, deren Kapazität im wesentlichen nach der Gleichung

$$C = \frac{|\tan\varphi|}{\omega \cdot R_{Sh}} \qquad bzw. \quad C = \frac{|\tan\varphi|}{\omega \cdot |Z_b|}$$

bemessen ist,
wobei

C die Kapazität der Kompensationsschaltung
$\omega$ die Kreisfrequenz
$\varphi$ den Phasenfehler zwischen Primär- und Sekundärstrom
$R_{Sh}$ den Widerstand eines allfälligen Messshunts und
$\underline{Z}_b$ die Impedanz einer allfälligen Bürde

bedeuten.

Ein solcher Ringkern-Stromwandler erlaubt eine Kompensation des Phasenfehler auf deutlich unter 1°, wie noch erläutert werden wird, so dass auf diese Weise der Phasenfehler vollständig oder nahezu vollständig kompensiert ist.

Bei einem Ausführungsbeispiel des erfindungsgemässen Ringkern-Stromwandlers wird die Kapazität der Kompensationsschaltung aus der Summe der Kapazität eines Kabels und einer Zuschaltkapazität gebildet (z.B. beim Ringkern-Stromwandler mit Stromausgang).

Bei einem bevorzugten Ausführungsbeispiel des erfindungsgemässen Ringkern-Stromwandlers umfasst die Kompensationsschaltung zwei gegenpolig in Serie geschaltete Kondensatoren, vorzugsweise Tantal-Kondensatoren (trockene Elektrolyt-Kondensatoren), aber je nach maximal auftretender Spannung auch Nass-Elektrolytkondensatoren. Diese Kondensatoren sind bei gleicher Kapazität von ihrem Volumen her deutlich kleiner als die herkömmlichen Metall-Papier/Folien-Kondensatoren und daher wesentlich einfacher in einem Gehäuse unterzubringen, und zudem sind sie auch kostengünstiger.

Bei einer Weiterbildung dieses Ausführungsbeispiels des erfindungsgemässen Ringkern-Stromwandlers ist zu jedem der beiden gegenpolig in Serie geschalteten Kondensatoren eine Schutzdiode parallel geschaltet. Die Polung der Schutzdioden ist jeweils entgegengesetzt zur Polung des zugehörigen Kondensators. Die Schutzdioden dienen - wie ihr Name schon sagt - dem Schutz der Kondensatoren gegen Verpolung, da derartige Kondensatoren nur eine vergleichsweise geringe Spannung falscher Polung vertragen. Die Durchlassspannung der Dioden ist daher kleiner zu wählen als die maximale für die Kondensatoren verträgliche falsch gepolte Spannung.

Um den Ringkern-Stromwandler oder besser dessen sekundärseitige Komponenten und insbesondere die Elektrolyt-Kondensatoren gegen Überspannungen zu schützen, umfasst bei einem weiteren Ausführungsbeispiel die Kompensationsschaltung einen Varistor (Variable Resistor; ZnO-Ableiter, der beim Überschreiten einer bestimmten Spannung einen Kurzschluss darstellt). Der Varistor ist beispielsweise bei dem oben genannten Ausführungsbeispiel mit den gegenpolig in Serie geschalteten Kondensatoren parallel zu der Serienschaltung der beiden Kondensatoren geschaltet (und - sofern vorhanden - zu den Schutzdioden). Beim Auftreten von Überspannung verhindert der Varistor somit eine Zerstörung der Kondensatoren.

Bei einem weiteren Ausführungsbeispiel des erfindungsgemässen Ringkern-Stromwandlers weist der Ringkern einen (oder mehrere) Luftspalt(e) auf. Der Luftspalt dient zur Linearisierung der Magnetisierungskurve des Ringkerns, verringert allerdings die Induktivität des Stromwandlers und vergrössert damit den Phasenfehler zwischen Primär- und Sekundärstrom.

Ein weiterer Aspekt der Erfindung betrifft ein entsprechendes Verfahren zur Ermittlung des Primärstroms, wie es durch die Merkmale des unabhängigen Verfahrensanspruchs charakterisiert ist. Vorteilhafte Varianten des erfindungsgemässen Verfahrens ergeben sich aus den Merkmalen der abhängigen Verfahrensansprüche.

Im besonderen betrifft die Erfindung ein Verfahren zur Kompensation des Phasenfehlers zwischen dem Primärstrom und dem Sekundärstrom eines Ringkern-Stromwandlers, insbesondere für Mittel- und Hochspannungsanlagen. Der Ringkern-Stromwandler umfasst eine Primärleiter, welcher den Ringkern durchquert, sowie eine um den Ringkern gewickelte Sekundärwicklung und einen sekundärseitig vorgesehenen Messshunt oder eine Bürde. Zur Kompensation des Phasenfehlers wird sekundärseitig eine passive Kompensationsschaltung vorgesehen, deren Kapazität im wesentlichen nach der Gleichung

$$C = \frac{|\tan \varphi|}{\omega \cdot R_{Sh}} \qquad bzw. \quad C = \frac{|\tan \varphi|}{\omega \cdot |\underline{Z}|}$$

bemessen wird,
wobei

C     die Kapazität der Kompensationsschaltung

$\omega$     die Kreisfrequenz

$\varphi$     den Phasenfehler zwischen Primär- und Sekundärstrom

$R_{Sh}$     den Widerstand eines allfälligen Messshunts und

$\underline{Z}_b$     die Impedanz einer allfälligen Bürde

bedeuten.

Die Vorteile dieses Verfahrens und seiner nachfolgend genannten Varianten entsprechen jeweils den Vorteilen, die bereits weiter oben bei der Erläuterung des entsprechenden Ringkern-Transformators bzw. dessen Ausführungsbeispielen und Weiterbildungen genannt sind.

Bei einer Verfahrensvariante wird die Kapazität der Kompensationsschaltung aus der Summe der Kapazität eines Kabels und einer Zuschaltkapazität gebildet (z.B. Ringkern-Stromwandler mit Stromausgang). Zur Ermittlung der erforderlichen Zuschaltkapazität wird die Kabelkapazität von der (Gesamt-)Kapazität der Kompensationsschaltung subtrahiert.

So kann bei einer Variante des erfindungsgemässen Verfahrens eine Kompensationsschaltung mit zwei gegenpolig in Serie geschalteten Kondensatoren verwendet werden, wobei als Kondensatoren vorzugsweise Tantal-Kondensatoren verwendet werden, aber - je nach erforderlicher Spannungsfestigkeit - auch Nasselektrolyt-Kondensatoren in Betracht kommen können.

Bei einer Weiterbildung dieser Verfahrensvariante kann insbesondere auch eine Kompensationsschaltung verwendet werden, bei welcher zu jedem der beiden gegenpolig in Serie geschalteten Kondensatoren eine Schutzdiode parallel geschaltet ist und die Polung der Schutzdioden jeweils entgegengesetzt zur Polung des zugehörigen Kondensators ist.

Bei einer weiteren Verfahrensvariante kann eine Kompensationsschaltung mit einem Varistor zum Schutz gegen Überspannungen verwendet werden. Schliesslich kann bei einer weiteren Verfahrensvariante ein Ringkern mit einem oder mit mehreren Luftspalten verwendet werden.

Wie bereits erwähnt, entsprechen die Vorteile der jeweiligen Verfahrensvarianten denjenigen Vorteilen, die bei der Erläuterung der entsprechenden Ausführungsbeispiele des Ringkern-Transformators genannt sind.

Weitere vorteilhafte Aspekte der Erfindung ergeben sich aus der nachfolgenden Erläuterung eines vorteilhaften Ausführungsbeispiels mit Hilfe der Zeichnung. Es zeigen in schematischer Darstellung:

Fig. 1     das auf die Primärseite bezogene Ersatzschaltbild eines Ausführungsbeispiels des erfindungsgemässen Ringkern-Stromwandlers zur Erläuterung des Kompensationsprinzips,

Fig. 2     das Zeigerdiagramm des Primärstroms bezogen auf die Spannung am Messshunt eines Ringkern-Stromwandlers mit Spannungsausgang

und

Fig. 3     einen Ausschnitt der Sekundärseite des erfindungsgemässen Stromwandlers mit einem Beispiel einer Kompensationsschaltung.

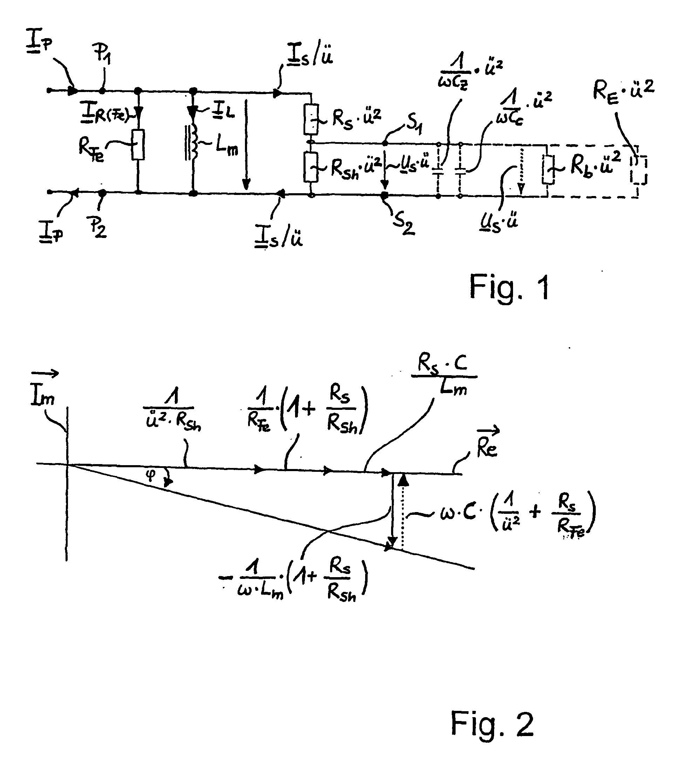

In dem Fig. 1 gezeigten, auf die Primärseite bezogenen, Ersatzschaltbild eines Ausführungsbeispiels des erfindungsgemässen Ringkern-Stromwandlers bezeichnen $R_{Fe}$ den äquivalenten linearen Widerstand für die Eisenverluste und Lm die Induktivität des Stromwandlers. Der Widerstand der Sekundärwicklung ist mit $R_S$ bezeichnet, und der Messshunt mit $R_{Sh}$. Der Messshunt $R_{Sh}$ kann dabei als Teil der Sekundärwicklung ausgebildet sein, wie in WO-A-98/58267 beschrieben. Da das in Fig. 1 gezeigte Ersatzschaltbild auf die Primärseite bezogen ist, sind diese Widerstände jeweils mit dem Faktor ü$^2$ belegt, also mit dem Quadrat des Übersetzungsverhältnisses ü, welches sich aus dem Quotienten der Windungszahl $N_P$ des Primärleiters und der Windungszahl $N_S$ der Sekundärwicklung ergibt. Ferner erkennt man noch die Kapazität $C_z$ der Zusatzkondensatoren und die Kabelkapazität $C_c$ der Leitungen. Im dargestellten Beispiel ist eine rein ohm'sche Bürde mit dem Widerstand $R_b$ (die grundsätzlich komplexe Impedanz $\underline{Z}_b$ der Bürde hat hier nur einen Realteil $R_b$, ist somit ein ohm'scher Widerstand) an den Sekundäranschlüssen $S_1$ und $S_2$ angedeutet. Der Betrag der Impedanzen der Zusatz-Kondensatoren beträgt $\frac{1}{\omega C_z} \cdot \ddot{u}^2$ bzw. diejenige des Kabels $\frac{1}{\omega C_c} \cdot \ddot{u}^2$. Diese Impedanzen sind - wie der ohm'sche Widerstand $R_b$ der Bürde - mit dem Faktor $\ddot{u}^2$ belegt, weil sie von der Sekundärseite auf die Primärseite transformiert wurden, da das Ersatzschaltbild auf die Primärseite bezogen ist. Die Gesamtkapazität C ergibt sich aus der Summe der Kapazitäten $C_z$ und $C_c$ zu $C=C_Z+C_C$. An den Sekundäranschlüssen $S_1$ und $S_2$ liegt die Spannung $\underline{U}_S \cdot \ddot{u}$ an, da die sekundärseitige Spannung $\underline{U}_S$ bei der Transformation auf die Primärseite mit dem Übersetzungsverhältnis $\ddot{u}$ zu multiplizieren ist. $R_E$ ist der Eingangswiderstand der angeschlossenen Verrechnungszähler, Kontroll- und/oder Schutzgeräte, der ebenfalls mit dem Faktor $\ddot{u}^2$ belegt ist, da das Ersatzschaltbild auf Primärseite bezogen ist.

Durch die Primäranschlüsse $P_1$ und $P_2$ fliesst der Primärstrom $\underline{I}_P$. Dieser Primärstrom $\underline{I}_P$ teilt sich auf in die Teilströme $\underline{I}_R(Fe)$ und $\underline{I}_L$ sowie in den Teilstrom $\underline{I}_S/\ddot{u}$, da der Sekundärstrom $\underline{I}_S$ aufgrund der Transformation auf die Primärseite durch das Übersetzungsverhältnis $\ddot{u}$ (siehe oben) zu dividieren ist.

Je nach Stromwandlertyp (Spannungsausgang, Stromausgang) kann in Fig. 1 der Messshunt $R_{Sh}$ oder die Bürde $R_b$ vorgesehen sein. Aus dem Ersatzschaltbild (Fig. 1) ergibt sich - mit der Vorraussetzung $R_E \gg R_{Sh}$ bzw. $R_E \gg R_b$ zwischen dem Primärstrom $\underline{I}_P$ und der Spannung $\underline{U}_S$ an den Sekundäranschlüssen $S_1$ und $S_2$ (bzw. hier am Messshunt $R_{Sh}$) der Zusammenhang entsprechend der nachfolgenden Gleichung

$$\frac{\underline{I}_P}{\ddot{u} \cdot \underline{U}_S} = \frac{1}{\ddot{u}^2 \cdot R_{Sh}} + \frac{1}{R_{Fe}} \cdot \left(1 + \frac{R_S}{R_{Sh}}\right) + \frac{R_S \cdot C}{L_m} - j\frac{1}{\omega L_m} \cdot \left(1 + \frac{R_S}{R_{Sh}}\right) + j\omega C \cdot \left(\frac{1}{\ddot{u}^2} + \frac{R_S}{R_{Fe}}\right) \quad [1]$$

Dieser Zusammenhang wird auch aus dem Zeigerdiagramm in Fig. 2 ersichtlich. Für den unkompensierten Stromwandler ist die Gesamtkapazität C gleich null (es ist noch keine Kapazität vorhanden). Dadurch ergibt sich der Phasenfehler $\varphi$ zwischen Primärstrom und der Spannung $\underline{U}_S$ (der Sekundärstrom $\underline{I}_S$ durch den Messshunt ist in Phase mit der Spannung $\underline{U}_S$) zu:

$$\tan \varphi = -\frac{\frac{1}{\omega \cdot L_m} \cdot \left(1 + \frac{R_S}{R_{Sh}}\right)}{\frac{1}{\ddot{u}^2 \cdot R_{Sh}} + \frac{1}{R_{Fe}} \cdot \left(1 + \frac{R_S}{R_{Sh}}\right)} \quad [2]$$

Mit

$$\frac{1}{\ddot{u}^2 \cdot R_{Sh}} \gg \frac{1}{R_{Fe}} \cdot \left(1 + \frac{R_S}{R_{Sh}}\right) \quad [3]$$

ergibt sich folgender Zusammenhang:

$$\frac{1}{\omega \cdot L_m} = |\tan \varphi| \cdot \frac{1}{\ddot{u}^2 \cdot (R_{Sh} + R_S)} \quad [4]$$

Für eine vollständige Kompensation muss der Imaginärteil des der Gleichung [1] gleich null sein (keine Pha-

sendifferenz zwischen $\underline{I}_P$ und $\underline{U}_S$), es muss also gelten:

$$\frac{1}{\omega \cdot L_m} \cdot \left(1 + \frac{R_S}{R_{Sh}}\right) = \omega \cdot C \cdot \left(\frac{1}{\ddot{u}^2} + \frac{R_S}{R_{Fe}}\right) \qquad [5]$$

Wird nun Gleichung [4] in Gleichung [5] eingesetzt, und berücksichtigt man ferner, dass $\frac{R_S}{R_{Fe}} << \frac{1}{\ddot{u}^2}$ ist, so ergibt sich für die Gesamtkapazität C:

$$C = \frac{|\tan\varphi|}{\omega \cdot R_{Sh}} \qquad [6a]$$

oder bei einer Bürde $\underline{Z}_b$ entsprechend:

$$C = \frac{|\tan\varphi|}{\omega \cdot |\underline{Z}_b|} \qquad [6b]$$

Aus Gleichung [6a] kann man erkennen, dass beispielsweise bei einer Halbierung der Grösse des Messshunts $R_{Sh}$ zur Kompensation die Gesamtkapazität C verdoppelt werden muss. Wird die Gesamtkapazität C so bestimmt wie es vorstehend beschrieben ist, kann der Phasenfehler $\varphi$ kompensiert werden, wie dies durch den punktierten Pfeil in Fig. 2 zu erkennen ist.

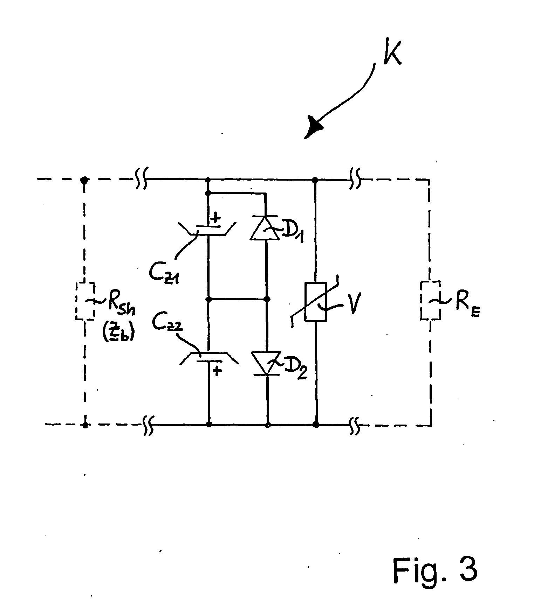

In Fig. 3 ist ein Ausführungsbeispiel für eine Kompensationsschaltung K gezeigt, mit deren Hilfe die zur Kompensation des Phasenfehlers zuschaltbare Zusatz-Kapazität $C_Z$ realisiert sein kann. Die Zusatz-Kapazität $C_Z$ wird hier durch die beiden Zusatz-Kondensatoren mit den Kapazitäten $C_{Z1}$ und $C_{Z2}$ gebildet. Wenn $C_{Z1}$ und $C_{Z2}$ jeweils gleich gross sind und die Reihenschaltung der beiden Zusatz-Kondensatoren die Zusatz-Kapazität $C_Z$ bildet, ergibt sich die Zusatz-Kapazität zu $C_Z = C_{Z1}/2 = C_{Z2}/2$. Soll die erforderliche Zusatz-Kapazität $C_Z$ zur Kompensation des Phasenfehlers $\varphi$ ermittelt werden, so ist zu berücksichtigen, dass sich die Gesamtkapazität C zu $C = C_Z + C_c$ ergibt, sodass von der zur Kompensation erforderlichen Gesamtkapzität C zuerst die Kabel-Kapazität $C_c$ allfälliger Leitungen zu subtrahieren ist, um die erforderliche zuschaltbare Zusatz-Kapazität $C_Z$ zu ermitteln. Jeweils gestrichelt dargestellt sind in Fig. 3 der Messshunt $R_{Sh}$ bzw. die Bürde $\underline{Z}_b$ und der Eingangswiderstand $R_E$ des Messystems. Da $R_E >> R_{Sh}$ bzw. $|\underline{Z}_b|$ ist, wird der Eingangswiderstand $R_E$ bei der Ermittlung der zur Kompensation erforderlichen Kapazität nicht berücksichtigt.

Die beiden Kondensatoren der Kompensationsschaltung K mit den Kapazitäten $C_{Z1}$ und $C_{Z2}$ sind gegenpolig in Serie geschaltet. Bei den in Fig. 3 gezeigten Kondensatoren handelt es sich um Elektrolyt-Kondensatoren, vorzugsweise um Tantal-Kondensatoren. Elektrolyt-Kondensatoren (z.B. Nass-Elektrolyt-Kondensatoren) generell, und insbesondere auch die genannten Tantal-Kondensatoren (Trocken-Elektrolyt-Kondensatoren) weisen bei gleicher Kapazität im Vergleich zu herkömmlichen Metall-Papier-Kondensatoren ein wesentlich geringeres Volumen auf und sind daher wesentlich einfacher in einem Gehäuse unterzubringen. Ausserdem sind sie auch von der Kostenseite her günstiger als die Metall-Papier-Kondensatoren. Ob Tantal-Kondensatoren oder Nass-Elektrolyt-Kondensatoren verwendbar sind, hängt unter anderem auch davon ab, wie die maximale Spannung ist, die an den Kondensatoren anliegen kann. Die Spannungsfestigkeit von Nass-Elektrolyt-Kondensatoren liegt nämlich höher (sie beträgt z.B. 500V für Aluminium-Elektrolyt-Kondensatoren) als diejenige von Tantal-Kondensatoren (sie beträgt z.B. 50V).

Elektrolyt-Kondensatoren sind allerdings empfindlich gegen Verpolung. Eine falsch gepolte Spannung an Elektrolyt-Kondensatoren, die einen gewissen (vergleichsweise geringen) Wert überschreitet, führt zu einer Beschädigung bzw. Zerstörung der Elektrolyt-Kondensatoren. Um dies zu verhindern, sind die Kondensatoren durch Schutzdioden $D_1$ bzw. $D_2$ geschützt, weshalb zu jedem der beiden in Serie geschalteten Kondensatoren eine Schutzdiode $D_1$ bzw. $D_2$ parallel geschaltet ist. Die Polung der jeweiligen Schutzdiode $D_1$ bzw. $D_2$ ist jedoch umgekehrt zur Polung des zugehörigen Kondensators. Die Durchlassspannung der jeweiligen Schutzdiode $D_1$ bzw. $D_2$, also die Spannung, bei welcher die jeweilige Schutzdiode $D_1$ bzw. $D_2$ hoch leitfähig wird, liegt unterhalb der maximal verträglichen falsch gepolten Spannung der Elektrolyt-Kondensatoren. Beim Auftreten einer falsch gepolten Spannung wird also die jeweilige Schutzdiode $D_1$

bzw. $D_2$ gut zu leiten beginnen, noch bevor der jeweilige Elektrolyt-Kondensator beschädigt bzw. zerstört werden kann.

Der zu der Serienschaltung der Elektrolyt-Kondensatoren (und den Schutzdioden) parallel geschaltete Varistor V (Variable Resistor z.B. der Technologie ZnO), ein spannungsabhängiger Widerstand, der beim Überschreiten einer bestimmten Spannung einen Kurzschluss darstellt, schützt die Kompensationsschaltung und insbesondere die Kondensatoren gegen auftretende Überspannungen.

Während die bereits weiter oben genannte Grösse des Betragsfehlers $|\varepsilon|$ bei dem Ringkern-Stromwandler mit Spannungsausgang durch die Dimensionierung des Messshunts $R_{Sh}$ auf den geforderten Betragfehler hin abgeglichen werden kann, soll im folgenden noch anhand eines Zahlenbeispiels die Dimensionierung der Zusatz-Kapazität $C_Z$ für einen Ringkern-Stromwandler mit Spannungsausgang erläutert werden. Dabei ist der Phasenfehler $\varphi$ des nicht kompensierten Stromwandlers zu messen, was mit einer geeigneten Messbrücke erfolgen kann. Die Kabel-Kapazität $C_c$ hängt von der Länge der Messleitung ab und ist bekannt. Die Grösse des Messshunts $R_{Sh}$ betrag $R_{Sh}$=1.125Ω, wobei zu beachten ist, dass auch in Bezug auf die Konstanz des Betragsfehlers $|\varepsilon|$ vorzugsweise Messshunts mit hoher Temperaturkonstanz, z.B. Messshunts mit Widerstandsdraht vom Typ ISAOHM® der Firma Isabellenhütte, Dillenburg (Deutschland), zu verwenden sind. Die Arbeitsfrequenz sei für das vorliegende Beispiel f = 50Hz, also $\omega$ = 314 s$^{-1}$. Die Grösse des Phasenfehlers $\varphi$ ist durch die Vormessung ermittelt worden zu $\varphi$ = 30'.

Daraus ergibt sich für die erforderliche gesamtkapazität C entsprechend der Gleichung [4]:

$$C = \frac{|\tan\varphi|}{\omega \cdot R_{Sh}} = \frac{\left|\tan\left(\frac{1}{60}\cdot 30\right)\right|}{314\left[\frac{1}{s}\right]\cdot 1.125\left[\frac{V}{A}\right]} = 25\cdot 10^{-6}\frac{As}{V} = 25\mu F$$

Schaltet man zwei Elektrolyt-Kondensatoren gleicher Kapazität in Reihe, so wie dies anhand von Fig. 3 gezeigt ist, so ergibt sich die Kapazität der Serienschaltung zur Hälfte der Einzelkapazitäten. Somit ergibt sich bei einer Serienschaltung von zwei Kondensatoren der Kapazität $C_{Z1}$ bzw. $C_{Z2}$ von $C_{Z1}$ =$C_{Z2}$ = 47μF die Zuschalt-Kapazität zu $C_Z$

= 23.5μF. Daraus ergibt sich wegen $C = \dfrac{|\tan\varphi|}{\omega \cdot R_{Sh}}$ mit den oben angegebenen Werten für C, $\omega$ und $R_{Sh}$ (mit der

Vereinfachung $\tan\varphi \approx \varphi$ für kleine Winkel $\varphi$) ein Winkel $\varphi$ = 0.48° = 28.5'. Der nach der Kompensation auftretende Phasenfehler - ohne Berücksichtigung einer allfälligen Kabelkapazität (die typischerweise etwa im Bereich von 50-200 pF/m liegt) - beträgt nur noch 1.5' (Winkelminuten).

Bei einem Nennstrom von $I_P$ = 1.25kA, einem Übersetzungsverhältnis ü = 1:2500, einem Sekundärwiderstand $R_S$ = 12.6Ω ergibt sich eine Betriebsspannung am Messshunt $R_{Sh}$ von $U_S \approx 0.5V$, bei vollverlagertem Kurzschlussstrom von 25kA eine Spannung von 35V. Diese im Kurzschlussfall auftretende maximale Spannung muss für die Kondensatoren verträglich sein, was für die oben erwähnten Tantal-Kondensatoren wie auch für Nass-Elektrolyt-Kondensatoren kein Problem darstellt.

In gleicher Weise ist dies auch für Standard-Stromwandler mit einer quasi konstanten Belastungsimpedanz $\underline{Z}_b$ der Bürde anwendbar. Bürden mit einem positiven oder negativen Phasenwinkel werden bei der Messung des Phasenfehlers $\varphi$ automatisch berücksichtigt.

Zu erwähnen ist noch, dass Ringkern-Stromwandler mit einem oder mehreren Luftspalten insofern besonders vorteilhaft sind, als diese Luftspalte zur Linearisierung der Magnetisierungskennlinie wesentlich beitragen.

**Patentansprüche**

1. Ringkern-Stromwandler, insbesondere für Mittel- und Hochspannungsanlagen, mit einem Primärleiter, der den Ringkern durchquert, sowie mit einer um den Ringkern gewickelten Sekundärwicklung, wobei sekundärseitig ein Messshunt ($R_{Sh}$) oder eine Bürde ($\underline{Z}_b$) vorgesehen ist, **dadurch gekennzeichnet, dass** zur Kompensation des Phasenfehlers ($\varphi$) zwischen Primärstrom ($I_P$) und Sekundärstrom ($I_S$) sekundärseitig eine passive Kompensationsschaltung (K) vorgesehen ist, deren Kapazität (C) im wesentlichen nach der Gleichung

$$C = \frac{|\tan\varphi|}{\omega \cdot R_{Sh}} \qquad bzw. \quad C = \frac{|\tan\varphi|}{\omega \cdot |\underline{Z}|}$$

bemessen ist,
wobei

> C die Kapazität der Kompensationsschaltung
> $\omega$ die Kreisfrequenz
> $\varphi$ den Phasenfehler zwischen Primär- und Sekundärstrom
> $R_{Sh}$ den Widerstand eines anfälligen Messshunts und
> $Z_b$ die Impedanz einer allfälligen Bürde

bedeuten.

2. Ringkern-Stromwandler nach Anspruch 1, bei welchem die Kapazität (C) der Kompensationsschaltung (K) aus der Summe der Kapazität ($C_C$) eines Kabels und einer Zuschaltkapazität ($C_Z$) gebildet wird.

3. Ringkern-Stromwandler nach einem der Ansprüche 1 oder 2, bei welchem die Kompensationsschaltung (K) zwei gegenpolig in Serie geschaltete Kondensatoren ($C_{Z1}$, $C_{Z2}$) umfasst.

4. Ringkern-Stromwandler nach Anspruch 3, bei welchem die gegenpolig in Serie geschalteten Kondensatoren ($C_{Z1}$, $C_{Z2}$) Tantal-Kondensatoren sind.

5. Ringkern-Stromwandler nach einem der Ansprüche 3 oder 4, bei welchem zu jedem der beiden gegenpolig in Serie geschalteten Kondensatoren ($C_{Z1}$, $C_{Z2}$) eine Schutzdiode ($D_1$,$D_2$) parallel geschaltet ist und die Polung der Schutz-dioden ($D_1$,$D_2$) jeweils entgegengesetzt zur Polung des zugehörigen Kondensators ($C_{Z1}$, $C_{22}$) ist.

6. Ringkern-Stromwandler nach einem der vorangehenden Ansprüche, bei welchem die Kompensationsschaltung (K) einen Varistor (V) umfasst zum Schutz gegen Überspannungen.

7. Ringkern-Stromwandler nach einem der vorangehenden Ansprüche, bei welchem der Ringkern einen oder mehrere Luftspalte aufweist.

8. Verfahren zur Kompensation des Phasenfehlers zwischen dem Primärstrom ($I_P$) und dem Sekundärstrom eines Ringkern-Stromwandlers, insbesondere für Mittel- und Hochspannungsanlagen, wobei der Ringkern-Stromwandler einen Primärleiter umfasst, welcher den Ringkern durchquert, sowie eine um den Ringkern gewickelte Sekundärwicklung und einen sekundärseitig vorgesehenen Messshunt ($R_{Sh}$) oder eine Bürde ($\underline{Z}_b$), **dadurch gekennzeichnet, dass** zur Kompensation des Phasenfehlers ($\varphi$) sekundärseitig eine passive Kompensationsschaltung (K) vorgesehen wird, deren Kapazität (C) im wesentlichen nach der Gleichung

$$C = \frac{|\tan\varphi|}{\omega \cdot R_{Sh}} \qquad bzw. \quad C = \frac{|\tan\varphi|}{\omega \cdot |\underline{Z}|}$$

bemessen wird, wobei

> C die Kapazität der Kompensationsschaltung
> $\omega$ die Kreisfrequenz
> $\varphi$ den Phasenfehler zwischen Primär- und Sekundärstrom
> $R_{Sh}$ den Widerstand eines allfälligen Messshunts und
> $\underline{Z}_b$ die Impedanz einer allfälligen Bürde

bedeuten.

9. Verfahren nach Anspruch 8, bei welchem die Kapazität (C) der Kompensationsschaltung (K) aus der Summe der Kapazität ($C_C$) eines Kabels und einer Zuschaltkapazität ($C_Z$) gebildet wird, wobei zur Ermittlung der Zuschaltkapazität ($C_Z$) die Kapazität ($C_C$) des Kabels von der Kapazität (C) der Kompensationsschaltung (K) subtrahiert wird.

10. Verfahren nach einem der Ansprüche 8 oder 9, bei welchem eine Kompensationsschaltung (K) mit zwei gegenpolig in Serie geschalteten Kondensatoren ($C_{Z1}$,$C_{Z2}$) verwendet wird.

11. Verfahren nach Anspruch 10, bei welchem als Kondensatoren ($C_{Z1}$,$C_{Z2}$) Tantal-Kondensatoren verwendet werden.

12. Verfahren nach Anspruch 11 oder 12, bei welchem eine Kompensationsschaltung (K) verwendet wird, bei welcher zu jedem der beiden gegenpolig in Serie geschalteten Kondensatoren ($C_{Z1}$,$C_{Z2}$) eine Schutzdiode ($D_1$, $D_2$) parallel geschaltet ist und die Polung der Schutzdioden ($D_1$,$D_2$) jeweils entgegengesetzt zur Polung des zugehörigen Kondensators ($C_{Z1}$,$C_{Z2}$) ist.

13. Verfahren nach einem der Ansprüche 8 bis 12, bei welchem eine Kompensationsschaltung (K) mit einem Varistor (V) zum Schutz gegen Überspannungen verwendet wird.

14. Verfahren nach einem der Ansprüche 8 bis 13, bei welchem ein Ringkern mit einem oder mit mehreren Luftspalten verwendet wird.

**Claims**

1. Toroidal core current transformer, particularly for medium high-voltage and high-voltage systems, with a primary conductor that traverses the toroidal core and a secondary winding that is wound around the toroidal core, wherein a measuring shunt ($R_{Sh}$) or a burden ($\underline{Z}_b$) is provided on the secondary side, **characterized in that** a passive compensation circuit (K) is provided on the secondary side in order to compensate the phase error ($\varphi$) between the primary current ($\underline{I}_P$) and the secondary current ($\underline{I}_S$), wherein the capacitance (C) of said compensation circuit is essentially rated in accordance with the equation

$$ C = \frac{|\tan \varphi|}{\omega \cdot R_{Sh}} \quad or \quad C = \frac{|\tan \varphi|}{\omega \cdot |\underline{Z}_b|}, $$

respectively,
wherein
C represents the capacitance of the compensation circuit,
$\omega$ represents the radian frequency,
$\varphi$ represents the phase error between the primary and the secondary current,
$R_{Sh}$ represents the resistance of an optional measuring shunt and
$\underline{Z}_b$ represents the impedance of an optional burden.

2. Toroidal core current transformer according to Claim 1, wherein the capacitance (C) of the compensation circuit (K) is formed by the sum of the capacitance ($C_C$) of a cable and an add-on capacitance ($C_Z$).

3. Toroidal core current transformer according to Claim 1 or 2, wherein the compensation circuit (K) comprises two capacitors ($C_{Z1}$, $C_{Z2}$) that are connected in series with opposite polarization.

4. Toroidal core current transformer according to Claim 3, wherein the capacitors ($C_{Z1}$, $C_{Z2}$) that are connected in series with opposite polarization consist of tantalum capacitors.

5. Toroidal core current transformer according to Claim 3 or 4, wherein a protective diode ($D_1$, $D_2$) is connected in parallel to each of the two capacitors ($C_{Z1}$, $C_{Z2}$) that are connected in series with opposite polarization, and wherein the polarization of the protective diodes ($D_1$, $D_2$) respectively opposes the polarization of the corresponding capacitor ($C_{Z1}$, $C_{Z2}$).

6. Toroidal core current transformer according to one of the preceding claims, wherein the compensation circuit (K) comprises a varistor (V) as protection against overvoltages.

7. Toroidal core current transformer according to one of the preceding claims, wherein the toroidal core comprises one or more air gaps.

8. Method for compensating the phase error between the primary current ($\underline{I}_P$) and the secondary current of a toroidal core current transformer, particularly for medium high-voltage and high-voltage systems, wherein the toroidal core current transformer comprises a primary conductor that traverses the toroidal core, as well as a secondary winding that is wound around the toroidal core and a measuring shunt ($R_{Sh}$) or a burden ($\underline{Z}_b$) that is provided on the secondary side, **characterized in that** a passive compensation circuit (K) is provided on the secondary side in order to compensate the phase error ($\varphi$), wherein the capacitance (C) of said compensation circuit is essentially rated in accordance with the equation

$$ C = \frac{\left|\tan\varphi\right|}{\omega \cdot R_{Sh}} \quad \text{or} \quad C = \frac{\left|\tan\varphi\right|}{\omega \cdot \left|\underline{Z}_b\right|} , $$

respectively,
wherein
C represents the capacitance of the compensation circuit,
$\omega$ represents the radian frequency,
$\varphi$ represents the phase error between the primary and the secondary current,
$R_{Sh}$ represents the resistance of an optional measuring shunt and
$\underline{Z}_b$ represents the impedance of an optional burden.

9. Method according to Claim 8, wherein the capacitance (C) of the compensation circuit (K) is formed by the sum of the capacitance ($C_C$) of a cable and an add-on capacitance ($C_Z$), and wherein the capacitance ($C_C$) of the cable is subtracted from the capacitance (C) of the compensation circuit (K) in order to determine the add-on capacitance ($C_Z$).

10. Method according to Claim 8 or 9, wherein the compensation circuit (K) used comprises two capacitors ($C_{Z1}$, $C_{Z2}$) that are connected in series with opposite polarization.

11. Method according to Claim 10, wherein the capacitors ($C_{Z1}$, $C_{Z2}$) used consist of tantalum capacitors.

12. Method according to Claim 11 or 12, wherein a compensation circuit (K) is used in which a protective diode ($D_1$, $D_2$) is connected in parallel to each of the two capacitors ($C_{Z1}$, $C_{Z2}$) that are connected in series with opposite polarization, and wherein the polarization of the protective diodes ($D_1$, $D_2$) respectively opposes the polarization of the corresponding capacitor ($C_{Z1}$, $C_{Z2}$)

13. Method according to one of Claims 8 to 12, wherein a compensation circuit (K) is used that comprises a varistor (V) as protection against overvoltages.

14. Method according to one of Claims 8 to 13, wherein a toroidal core with one or more air gaps is used.

**Revendications**

1. Transformateur de courant à noyau toroïdal, notamment pour des installations de moyenne et de haute tensions, comprenant :

    - un conducteur primaire qui traverse le noyau toroïdal ainsi qu'un enroulement secondaire enroulé autour du noyau toroïdal,
    - un shunt de mesure ($R_{Sh}$) ou une charge ($Z_b$) prévue du côté secondaire,

**caractérisé en ce que**

pour compenser le déphasage ($\varphi$) entre le courant primaire ($I_P$) et le courant secondaire ($I_S$), il est prévu un circuit de compensation passif (K) dont la capacité (C) est pratiquement donnée par les équations suivantes :

$$C = \frac{\left| \tan \varphi \right|}{\omega \cdot R_{Sh}} \qquad \text{ou} \qquad C = \frac{\left| \tan \varphi \right|}{\omega \cdot \left| \underline{Z}_b \right|}$$

dans lesquelles:

C est la capacité du circuit de compensation,
$\omega$ est la fréquence circulaire,
$\varphi$ est le déphasage entre le courant primaire et le courant secondaire,
$R_{Sh}$ est la résistance d'un shunt de mesure éventuel,
$\underline{Z}_b$ est l'impédance d'une charge éventuelle.

2. Transformateur de courant à noyau toroïdal selon la revendication 1,
dans lequel
la capacité (C) du circuit de compensation (K) se compose de la somme de la capacité ($C_C$) d'un câble et d'une capacité supplémentaire ($C_Z$).

3. Transformateur de courant à noyau toroïdal selon la revendication 1 ou 2,
dans lequel
le circuit de compensation (K) comporte deux condensateurs ($C_{Z1}$, $C_{Z2}$) branchés en série avec des polarités opposés.

4. Transformateur de courant à noyau toroïdal selon la revendication 3,
dans lequel
les condensateurs ($C_{Z1}$, $C_{Z2}$) branchés en série avec des polarités opposés sont des condensateurs au tantale.

5. Transformateur de courant à noyau toroïdal selon la revendication 3 ou 4,
dans lequel
pour chacun des deux condensateurs ($C_{Z1}$, $C_{Z2}$) branchés en série avec des polarités opposés, il est prévu une diode de protection ($D_1$, $D_2$) branchée en parallèle et la polarité des diodes de protection ($D_1$, $D_2$) est chaque fois opposée à la polarité du condensateur associé ($C_{Z1}$, $C_{Z2}$).

6. Transformateur de courant à noyau toroïdal selon les revendications précédentes,
dans lequel
le circuit de compensation (K) comprend un varistor (V) pour la protection contre les surtensions.

7. Transformateur de courant à noyau toroïdal selon les revendications précédentes,
dans lequel
le noyau toroïdal comporte un ou plusieurs entrefers.

8. Procédé de compensation du déphasage entre le courant primaire ($I_p$) et le courant secondaire d'un transformateur de courant à noyau toroïdal, notamment pour des installations de moyenne et de haute tensions,
selon lequel
le transformateur de courant à noyau toroïdal comporte un conducteur primaire traversant le noyau toroïdal, un enroulement secondaire bobiné autour du noyau toroïdal et un shunt de mesure ($R_{Sh}$) ou une charge ($Z_b$) du côté secondaire,
**caractérisé en ce que**
pour compenser le déphasage ($\varphi$) il est prévu, côté secondaire, un circuit de compensation passif (K) dont la capacité (C) est pratiquement donnée par les équations suivantes :

$$C = \frac{\left| \tan \varphi \right|}{\omega \cdot R_{Sh}} \qquad \text{ou} \qquad C = \frac{\left| \tan \varphi \right|}{\omega \cdot \left| \underline{Z}_b \right|}$$

dans lesquelles :

C est la capacité du circuit de compensation,
$\omega$ est la fréquence circulaire,
$\varphi$ est le déphasage entre le courant primaire et le courant secondaire,
$R_{Sh}$ est la résistance d'un shunt de mesure éventuel,
$\underline{Z}_b$ est l'impédance d'une charge éventuelle.

9. Procédé selon la revendication 8,
selon lequel
la capacité (C) du circuit de compensation (K) se compose de la somme de la capacité ($C_C$) d'un câble et d'une capacité supplémentaire ($C_Z$), et pour déterminer la capacité supplémentaire (Cz), on retranche la capacité ($C_C$) du câble de la capacité (C) du circuit de compensation (K).

10. Procédé selon la revendication 8 ou 9,
selon lequel
on utilise un circuit de compensation (K) ayant deux condensateurs ($C_{Z1}$, $C_{Z2}$) branchés en série avec des polarités opposées.

11. Procédé selon la revendication 10,
selon lequel
les condensateurs ($C_{Z1}$, $C_{Z2}$) utilisés sont des condensateurs au tantale.

12. Procédé selon la revendication 11 ou 12,
selon lequel
on utilise un circuit de compensation (K) dans lequel pour chacun des deux condensateurs ($C_{Z1}$, $C_{Z2}$) branchés en série avec des polarités opposées on branche en parallèle une diode de protection ($D_1$, $D_2$), la polarité des diodes de protection ($D_1$, $D_2$) étant chaque fois opposée à la polarité du condensateur associé ($C_{Z1}$, $C_{Z2}$).

13. Procédé selon les revendications 8 à 12,
selon lequel
on utilise un circuit de compensation (K) comprenant un varistor (V) pour la protection contre les surtensions.

14. Procédé selon les revendications 8 à 13,
selon lequel
on utilise un noyau toroïdal ayant un ou plusieurs entrefers.

$\underline{I}_P$ $P_1$ $\underline{I}_s/\ddot{u}$ $\frac{1}{\omega C_z}\cdot\ddot{u}^2$ $\frac{1}{\omega C_e}\cdot\ddot{u}^2$ $R_E\cdot\ddot{u}^2$

$\underline{I}_{R(Fe)}$ $\underline{I}_L$ $R_s\cdot\ddot{u}^2$ $S_1$

$R_{Fe}$ $L_m$ $R_{Sh}\cdot\ddot{u}^2$ $\underline{U}_s\cdot\ddot{u}$ $R_b\cdot\ddot{u}^2$

$\underline{I}_P$ $P_2$ $\underline{I}_s/\ddot{u}$ $S_2$ $\underline{U}_s\cdot\ddot{u}$

## Fig. 1

$\vec{I}_m$

$\frac{1}{\ddot{u}^2\cdot R_{Sh}}$ $\frac{1}{R_{Fe}}\cdot\left(1+\frac{R_s}{R_{Sh}}\right)$ $\frac{R_s\cdot C}{L_m}$

$\varphi$ $\vec{Re}$

$\omega\cdot C\cdot\left(\frac{1}{\ddot{u}^2}+\frac{R_s}{R_{Fe}}\right)$

$-\frac{1}{\omega\cdot L_m}\cdot\left(1+\frac{R_s}{R_{Sh}}\right)$

## Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4198595 A
- US 6670799 B
- US 6094044 A
- WO 9858267 A